(19) Europäisches Patentamt

European Patent Office

Office européen des brevets

(11) Veröffentlichungsnummer: **0 425 722 A1**

# (12) EUROPÄISCHE PATENTANMELDUNG

(21) Anmeldenummer: 89120220.2

(22) Anmeldetag: 31.10.89

(51) Int. Cl.⁵: **H05K 13/08**

(43) Veröffentlichungstag der Anmeldung:
**08.05.91 Patentblatt 91/19**

(84) Benannte Vertragsstaaten:
**AT BE CH DE ES FR GB GR IT LI NL SE**

(71) Anmelder: **Siemens Aktiengesellschaft
Wittelsbacherplatz 2
W-8000 München 2(DE)**

(72) Erfinder: **Schneider, Richard, Dr.
Egerländerstrasse 5**

**W-8028 Taufkirchen(DE)**
Erfinder: **Grasmüller, Hans
Kapellenstrasse 4
W-8083 Mammendorf(DE)**
Erfinder: **Ellinger, Georg, Dipl.-Ing.
Kapellenstrasse 3a
W-8025 Unterhaching(DE)**
Erfinder: **Stredele, Bernhard, Dipl.-Ing.
Achstrasse 7
W-8114 Uffing(DE)**

(54) **Anordnung zur Lageerkennung von Anschlussbeinchen.**

㉗ Bisher bekannte Systeme zur Prüfung der korrekten Länge und Ausrichtung von Anschlußbeinchen (1) von elektronischen Bauelementen (2), insbesondere SMD-Bauelemente, die mit dem Schattenwurf der beleuchteten Anschlußbeinchen (1) auf eine lichtdurchlässige Scheibe (3) arbeiten, bieten keine Möglichkeit, eine Verbiegung einzelner Anschlußbeinchen (1) aus einer Auflageebene heraus eindeutig zu erkennen. Durch die erfindungsgemäße Beleuchtung der Anschlußbeinchen (1) aus zwei unterschiedlichen Richtungen wird die Differenzierung bezüglich der Fehlererkennung verbessert. Es kann unterschieden werden, ob ein Anschlußbeinchen (1) lediglich zu kurz ist oder um eine Höhendifferenz (dz) nach oben gebogen ist. Die Anordnung arbeitet mit üblichen Bildaufnahmen (18) und Bildverarbeitungen (19). Als besonders vorteilhaft hat sich der Einsatz von Diodenzeilen zur Beleuchtung herausgestellt. Die Ausführung der lichtdurchlässigen Platte (3) als faseroptische Platte ist verbunden mit wesentlicher Verringerung der Empfindlichkeit gegenüber Fremdlicht.

## FIG 1

## ANORDNUNG ZUR LAGEERKENNUNG VON ANSCHLUSSBEINCHEN

Die Erfindung betrifft eine Anordnung zur Lageerkennung von Anschlußbeinchen elektronischer Bauelemente mittels Positionierung der elektronischen Bauelemente zumindest annähernd auf eine lichtdurchlässige Platte bei gleichzeitiger Beleuchtung der Anschlußbeinchen und Auswertung der Form der durch die Anschlußbeinchen auf der lichtdurchlässigen Platte erzeugten Abschattung mittels einer Bildaufnahme auf der dem elektronischen Bauelement gegenüberliegenden Seite der lichtdurchlässigen Platte mit angeschlossener Bildverarbeitung.

Auf dem Gebiet von Bestückautomaten, insbesondere von SMD-Bestückautomaten, werden durch die immer geringer werdenden Rastermaße der mit einer Vielzahl von Anschlußbeinchen versehenen Bauelemente zunehmend genauere Justagemöglichkeiten der Bauelemente relativ zu einer Bestückposition gefordert. Die SMD-Bauelemente (SMD = s̲urface m̲ounted d̲evice) mit dieser Vielzahl vo̲n Anschlu̲ßbeinchen m̲üssen unmittelbar vor dem Bestücken daraufhin geprüft werden, ob die Anschlußbeinchen die richtige Länge haben und richtig ausgerichtet sind.

Bisher bekannte Prüfsysteme ohne die Verwendung einer transparenten Platte und eines darauf erzeugten Schattens der Bauelemente bzw. der Anschlußbeinchen können entweder die für die Justage erforderliche Lageerkennung des gesamten Bauelementes bereitstellen oder beispielsweise die Beschaffenheit eines ganzen Loses gleichartiger SMD-Bauelemente prüfen. Hierbei werden die Bauelemente beleuchtet und direkt von einer Fernsehkamera betrachtet, wobei eine nachgeschaltete Bildauswerteeinheit die gewünschten Informationen liefert. Derartige Systeme können jedoch lediglich zweidimensional erkennen und kein nach oben gebogenes Beinchen detektieren. Andere Systeme arbeiten mit einer Vielzahl von Kameras, die ebenfalls die Anschlußbeinchen oder das Bauelement direkt betrachten und durch ver schiedene Ausrichtungen der einzelnen Kameras die entsprechende Lageabweichung der Anschlußbeinchen erfassen.

Diese bisher genannten Systeme sind entweder mit nicht genügender Erkennung von Ursachen von Lötfehlern, wie beispielsweise verbogene Anschlußbeinchen, oder mit hohem apparativen Aufwand verbunden.

Es ist bekannt, bei einem Prüfsystem für Bauelemente eine lichtdurchlässige Platte einzusetzen, auf der durch Beleuchtung der Bauelemente mit ihren Anschlußbeinchen eine Abschattung mit Schattenkanten erzeugt wird. Ein bisher bekanntes System ist im Prospekt "Lead Complanarity Detector" der Fa. TDK Electronics Europa GmbH, Components and Machine Divison, Harkort Str. 6, D-4030 Ratingen, West Germany vom Sept. 1988 beschrieben. Die hier offenbarte Anordnung erkennt, ob die Anschlußbeinchen alle gleichmäßig eben ausgerichtet sind oder ob ein oder mehrere Anschlußbeinchen einen Fehler aufweisen. Ein derartiger Fehler kann in einer Verkürzung oder in einer Verbiegung des Anschlußbeinchens bestehen. Unter der Verwendung einer Lichtquelle pro Beinchenreihe und einer halbtransparenten Platte, auf der das Bauelement aufgesetzt wird, wird der Schatten der Anschlußbeinchen auf der Platte von der dem Bauelement gegenüberliegenden Seite durch eine Kamera aufgenommen und ausgewertet.

Mit diesem System läßt sich beim Auftauchen eines Fehlers an einem Anschlußbeinchen keine Differenzierung durchführen, so daß erkannt werden kann, ob das Beinchen zu kurz oder verbogen, insbesondere nach oben gebogen ist.

Der Erfindung liegt die Aufgabe zugrunde, eine Anordnung zur Lageerkennung von Anschlußbeinchen elektronischer Bauelemente der eingangs beschriebenen Art bereitzustellen, mit der eine eindeutige Höhenerkennung von Anschlußbeinchen durchführbar ist.

Die Lösung dieser Aufgabe wird durch den kennzeichnenden Teil des Ansprüches 1 wiedergegeben.

Der Erfindung liegt die Erkenntnis zugrunde, daß durch die Beleuchtung der Anschlußbeinchen aus zwei unterschiedlichen Richtungen die dadurch auf der lichtdurchlässigen Platte entstehende Abschattung differenziert ausgewertet werden kann. Diese differenzierte Auswertung, der zwei zeitlich versetzt aufgenommene Schattenbilder mit entsprechenden Schattenkanten zugrundeliegen, erfaßt zum einen ein zu kurzes Anschlußbeinchen, wobei alle Anschlußbeinchen gleichmäßig ausgerichtet sein können und keines eine Verbiegung aufweist. Zum anderen kann eine Verbiegung eines Anschlußbeinchens nach oben erfaßt werden, egal, ob das Anschlußbeinchen eine korrekte Länge aufweist oder nicht. Um die Abschattung bzw. die Schattenkanten auf der lichtdurchlässigen Platte kontrastreich zu erzeugen, wird eine Streuschicht innerhalb der lichtdurchlässigen Platte vorgesehen. Hierdurch wird ermöglicht, die Maße bzw. Lage der Schattenkanten in der Ebene der Streuschicht mit hoher Auflösung zu detektieren.

Eine Ausgestaltung der Erfindung sieht den Einsatz von Lichtquellen vor, die annähernd paralleles Licht erzeugen. Mittels derartiger Lichtquellen kann eine exakte Beleuchtung der Anschlußbeinchen vorgenommen werden. Die ausreichende Parallelität und Richtung der Strahlungsbündel wird in der Regel durch Kollimatorlinsen bzw. durch den Einsatz von Blenden bewerkstelligt. Damit können Lichtquellen mit genügender Lichtleistung eingesetzt werden.

Eine weitere Ausgestaltung der Erfindung sieht den Einsatz von Lichtquellen in Form von Diodenzeilen vor. Da die Bauelemente, insbesondere die SMD-Bauelemente, an den länglichen Außenkanten nebeneinander aufgereihte Anschlußbeinchen aufweisen, ist es nötig, eine Lichtquelle, die die Form einer Lichtleiste hat, für die homogene Beleuchtung einer Seite eines Bauelementes einzusetzen. Dies kann in einfacher Weise durch Diodenzeilen geschehen.

Durch den Einsatz einer faseroptischen Platte wird die Intensität des in Richtung der Bildaufnahme gestreuten Lichtes im Vergleich zu einer Streuschicht deutlich erhöht. Damit wird der Einfluß von störendem Fremdlicht vermindert. Eine faseroptische Platte wird durch die Bündelung von Lichtwellenleitern erzeugt, wobei die Lichtwellenleiter teilweise miteinander verschmolzen werden und die Platte dadurch erzeugt wird, daß aus einem derartigen Bündel eine Scheibe senkrecht zur Achse herausgeschnitten wird. Somit liegen innerhalb der faseroptischen Platte eine große Anzahl von sich berührenden und senkrecht stehenden Lichtwellenleitern vor.

Im folgenden wird anhand von schematischen Figuren ein Ausführungsbeispiel beschrieben.

Die Figur 1 zeigt das Detektionsprinzip.

Die Figur 2 zeigt den prinzipiellen Aufbau eines Prüfsystemes.

Die Figur 3 zeigt eine Variante mit der Beleuchtung durch Diodenzeilen.

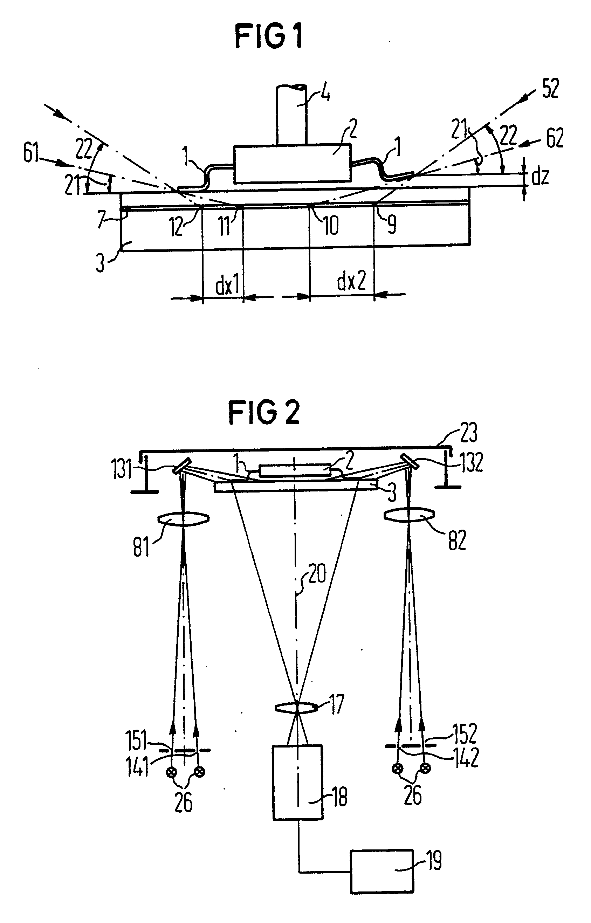

In der Figur 1 ist das Detektionsprinzip dargestellt. Ein elektronisches Bauelement 2 mit Anschlußbeinchen 1 wird mittels einer Halteeinrichtung 4, beispielsweise eine Saugpipette eines Bestückkopfes, auf eine lichtdurchlässige Platte 3 aufgesetzt. Es besteht die Möglichkeit, das Bauelement 2 in einem bestimmten geringen Abstand zur lichtdurchlässigen Platte 3 parallel zu dieser zu positionieren. Es ist jedoch besser, wenn das Bauelement 2 mit den Anschlußbeinchen 1 auf der Platte 3 aufsitzt, da dies die geometrischen Verhältnisse beim späteren Lötvorgang simuliert und eine Bezugsebene definiert, wodurch die nachfolgende Bildauswertung stark vereinfacht wird. Die Beleuchtung der Anschlußbeinchen 1 geschieht zum einen unter einem Winkel 21 mittels der Lichtstrahlen 61 und 62 und zum anderen unter einem Winkel 22 mittels der Lichtstrahlen 51 und 52. Die Winkel 21, 22 müssen nicht notwendigerweise für die hier dargestellte linke und rechte Seite gleich sein. An der innerhalb der lichtdurchlässigen Platte 3 dargestellten Streuschicht 7 entstehen die Schattenkanten der Abschattung. Bei einer Beleuchtung unter einem Winkel 21 mittels der Lichtbündel bzw. Lichtstrahlen 61, 62 entstehen die Schattenkanten 11, 10. Bei einer Beleuchtung unter dem Winkel 22 mittels der Lichtstrahlen 51, 52 entstehen die Schattenkanten 12 und 9. Sind wie beim linken Anschlußbeinchen 1 eine korrekte Länge und eine korrekte Ausrichtung vorhanden, so wird durch eine angeschlossene Bildaufnahme 18 und Bildverarbeitung 19 kein Fehler festgestellt. Dabei wird der Abstand dx1 zwischen den Schattenkanten 11 und 12 ausgewertet. Für den Fall, daß das rechte Anschlußbeinchen 1 hochgebogen ist, entsteht durch die beiden hintereinanderfolgenden Beleuchtungen zwischen den Schattenkanten 9 und 10 der Abstand dx2. Falls diese beiden Abstände dx1 und dx2 verschieden sind, so liegen die Anschlußbeinchen 1 in unterschiedlicher Höhe entsprechend der Höhendifferenz dz. Eine Prüfung kann beispielsweise durch die Beleuchtung mittels der Lichtstrahlen 61, 62 unter dem Winkel 21, einen Defekt an irgendeinem Anschlußbeinchen erkennen. Dies muß jedoch noch keine Negativentscheidung mit einer Elimination des Bauelementes 2 zur Folge haben. Durch die zweite Beleuchtung mittels der Lichtstrahlen 51, 52 aus der zweiten Richtung unter dem Winkel 22 werden durch die unterschiedlich vorliegenden Schattenkanten Informationen darüber geliefert, ob dieses als defekt erkannte Anschlußbeinchen 1 hochgebogen ist, oder lediglich eine Verkürzung aufweist. Eine Verkürzung kann unter Umständen innerhalb bestimmter Toleranzgrenzen in Kauf genommen werden, führt also nicht zur Elimination. Eine Hochbiegung eines Anschlußbeinchens 1 muß, um Lötfehler zu vermeiden, zur Elimination des Bauelementes 2 führen.

In der Figur 2 ist unter einer Abdeckung 23 eine lichtdurchlässige Platte 3 mit einem aufgesetzten Bauelement 2 mit Anschlußbeinchen 1 dargestellt. Die Beleuchtung bzw. die Lichtstrahlen werden durch Lichtquellen 26 erzeugt, mittels Blenden 151, 152, 141, 142 und Kollimatorlinsen 81, 82 in annähernd paralleles Licht geformt und über Spiegel 131, 132 zum Umlenken auf die Anschlußbeinchen 1 geführt. Der hier dargestellte Aufbau der Anordnung ist annähernd symmetrisch bezogen auf eine optische Achse 20 angelegt. Auf dieser optischen Achse 20 befindet sich auch das Objektiv 17 und eine Fernsehkamera als Bildaufnahme 18. Über die Bildverarbeitung 19 werden die Informationen geliefert, die zur Elimination von defekten Bauelementen 2 führen bzw. diese als gut befinden.

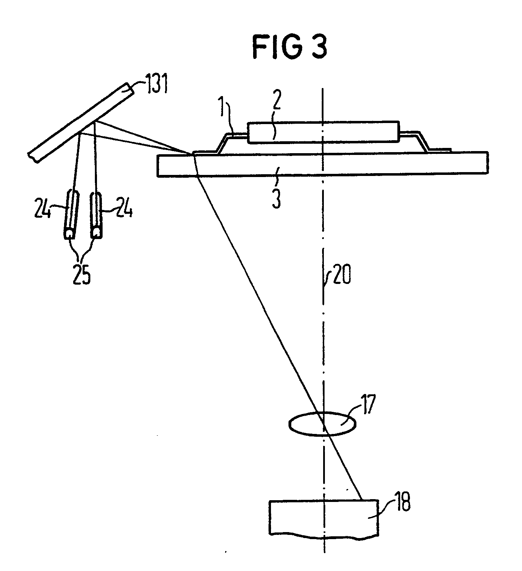

In der Figur 3 ist eine Variante der Anordnung dargestellt, die ebenfalls mittels einer Bildaufnahme 18, eines Objektives 17 und einer lichtdurchlässigen Platte 3 ein Bauelement 2 mit Anschlußbeinchen 1 prüfen kann. Die besondere Ausgestaltung hierbei besteht darin, daß als Lichtquellen Diodenzeilen 25, beispielsweise LED-Diodenzeilen (lichtemittierende Dioden), verwendet werden. Die Lochblenden 24 sorgen hier für eine Bündelung bzw. Parallelität der Strahlenbündel bzw. der Lichtstrahlen 51, 52, 61, 62.

Wird eine lichtdurchlässige Platte 3 mit einer Streuschicht 7 eingesetzt, so ist es zweckmäßig, diese Streuschicht 7 an der Oberseite, d.h. an der dem Bauelement 2 zugewendeten Seite, oder bis in eine Tiefe von ca. 1 mm parallel zur Platte 3 anzuordnen.

Ist die lichtdurchlässige Platte 3 eine faseroptische Platte, so wird eine Auflösung innerhalb der Auflageebene von ca. 35 μm möglich. Die Auflösung bezüglich der Höhe, d.h. senkrecht zur Auflageebene, beträgt 25 μm. Die Auflageebene ist gleichzusetzen mit der Oberfläche der transparenten Platte 3, die dem Bauelement 2 zugewandt ist.

Aus der Lage aller Schattenkanten kann in einfacher Weise die mittlere Lage und der Drehwinkel des Bauelementes 2 erfaßt werden. Dies bietet die Möglichkeit, die Lage des Bauelementes 2 mittels der Halteeinrichtung 4 durch eine Drehung zu korrigieren.

Um bei dem vorgegebenen Gesichtsfeld der Fernsehkamera bzw. der Bildaufnahme 18 eine geringe Meßunsicherheit zu erreichen, sollten die Abstände dx1, dx2 bei kleinen Höhendifferenzen dz möglichst große Werte annehmen. Dies wird im Idealfall dadurch erreicht, daß die Winkel 21, 22 möglichst stark voneinander differieren. Winkel 21 sollte demnach möglichst klein sein und gegen Null gehen und Winkel 22 möglichst bei 90° liegen. Aufgrund der Reflexions- und Streueigenschaften der transparenten Platte 3, sowie aus konstruktiven Gründen haben sich jedoch bestimmte Werte für die Winkel 21, 22 ergeben. Der Winkel 21 sollte ca. bei 8° liegen und der Winkel 22 ca. bei 15°.

Damit die Lichtquellen 26 bzw. die Diodenzeilen 25 die Halteeinrichtung 4 nicht behindern, werden die Lichtbündel über Spiegel 131, 132 umgelenkt. Ausreichende Parallelität und Ausrichtung der Lichtstrahlen 51, 52, 61, 62 wird durch die Kollimatorlinsen 81, 82 in Verbindung mit den Blenden 141, 142, 151, 152 gewährleistet. Durch serielles Einschalten der Lichtquellen 26 bzw. der Diodenzeilen 25 oder durch mechanisch bewegte Blenden oder in Ausnahmefällen durch Bewegung der Lichtquellen werden die einzelnen definiert ausgerichteten Lichtstrahlen 51, 52, 61, 62 erzeugt. An die Parallelität der Lichtstrahlen wird in der Regel keine hohe Anforderung gestellt.

Da bei der Ausführung entsprechend der Figur 3 genügend Licht durch die Vielzahl von Dioden zur Verfügung steht, kann unter Umständen die Abdeckung 23 entfallen. Dies gilt auch für den Fall, daß das zur Detektion verwendete Licht sich stark vom Umgebungslicht bzw. Störlicht unterscheidet. Hierbei kann eine Ausfilterung vorgenommen werden.

**Ansprüche**

1. Anordnung zur Lageerkennung von Anschlußbeinchen (1) elektronischer Bauelemente (2) mittels Positionierung der elektronischen Bauelemente (2) zumindest annähernd auf eine lichtdurchlässige, lichtstreuende Platte (3) bei gleichzeitiger Beleuchtung der Anschlußbeinchen (1) und Auswertung der Form der durch die Anschlußbeinchen (1) auf der lichtdurchlässigen Platte (3) erzeugten Abschattung mittels einer Bildaufnahme (18) auf der dem elektronischen Bauelement (2) gegenüberliegenden Seite der lichtdurchlässigen Platte (3) mit angeschlossener Bildverarbeitung (19),
**gekennzeichnet durch,**
mindestens eine Lichtquelle (26) zur aufeinanderfolgenden Beleuchtung der Anschlußbeinchen (1) aus zwei unterschiedlichen Richtungen.

2. Anordnung nach Anspruch 1,
**dadurch gekennzeichnet,**
daß die Lichtquellen (26) annähernd paralleles Licht erzeugen.

3. Anordnung nach Anspruch 1 oder 2,
**dadurch gekennzeichnet,**
daß die Lichtquellen (26) Diodenzeilen sind.

4. Anordnung nach einem der vorhergehenden Ansprüche,
**dadurch gekennzeichnet,**
daß die lichtdurchlässige Platte (3) eine faseroptische Platte ist.

# FIG 1

# FIG 2

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-301255 (SIEMENS AKTIENGESELLSCHAFT) * Spalte 2, Zeile 53 - Spalte 3, Zeile 54; Ansprüche 1-3; Figuren 4-6 * --- | 1-3 | H05K13/08 |
| A | EP-A-222072 (HITACHI) * Seite 10, Zeile 7 - Seite 11, Zeile 34; Figuren 23a, 23b, 24, 26 * ----- | 1 | |
| | | | RECHERCHIERTE SACHGEBIETE (Int. Cl.5) |
| | | | H05K G01B |

Der vorliegende Recherchenbericht wurde für alle Patentansprüche erstellt

| Recherchenort | Abschlußdatum der Recherche | Prüfer |
|---|---|---|
| DEN HAAG | 09 JULI 1990 | RIEUTORT A.S. |